# EUROPÄISCHE PATENTSCHRIFT

(11) **EP 1 671 167 B1**
(45) Veröffentlichungstag und Bekanntmachung des Hinweises auf die Patenterteilung: **25.05.2011**
(21) Anmeldenummer: 04789951.3
(22) Anmeldetag: 08.10.2004
(51) Int. Cl.: G02B 6/12

(54) **VERFAHREN ZUR HERSTELLUNG VON ELEKTRISCH-OPTISCHEN LEITERPLATTEN MIT POLYSILOXANWELLENLEITERN UND IHRE VERWENDUNG**
METHOD FOR THE PRODUCTION OF ELECTROOPTICAL PRINTED CIRCUIT BOARDS COMPRISING POLYSILOXANE WAVE GUIDES AND USE THEREOF
PROCEDE DE REALISATION DE CARTES DE CIRCUITS IMPRIMES ELECTRO-OPTIQUES COMPRENANT DES GUIDES D'ONDE POLYSILOXANE, ET LEUR UTILISATION

(30) Priorität: 10.10.2003 DE 10347331
(43) Veröffentlichungstag der Anmeldung: 21.06.2006
(73) Patentinhaber: Universität Dortmund, 44227 Dortmund (DE)
(72) Erfinder: NEYER, Andreas, 58638 Iserlohn (DE); RABE, Erik, 44137 Dortmund (DE); KOPETZ, Stefan, 58097 Hagen (DE)
(74) Vertreter: Schneider, Uwe
(86) Internationale Anmeldenummer: PCT/DE2004/002242
(87) Internationale Veröffentlichungsnummer: WO 2005/036221

(56) Entgegenhaltungen:
- EP-A- 1 142 682
- DE-A1- 19 523 580
- US-A- 6 088 492
- US-A1- 2003 108 269
- US-A1- 2003 179 979
- KOPETZ S ET AL: "Coupling of optoelectronic modules to optical layer in printed circuit boards (PCBs)" PROCEEDINGS OF THE SPIE - THE INTERNATIONAL SOCIETY FOR OPTICAL ENGINEERING SPIE-INT. SOC. OPT. ENG USA, Bd. 4942, 30. Oktober 2002 (2002-10-30), Seiten 282-286, XP002315409 ISSN: 0277-786X
- GRIESE E ET AL: "Self-aligned coupling of optical transmitter and receiver modules to board-integrated optical multimode waveguides" PROCEEDINGS OF THE SPIE - THE INTERNATIONAL SOCIETY FOR OPTICAL ENGINEERING SPIE-INT. SOC. OPT. ENG USA, Bd. 4455, 29. Juli 2001 (2001-07-29), Seiten 243-250, XP002315410 ISSN: 0277-786X
- LEHMACHER S ET AL: "INTEGRATION OF POLYMER OPTICAL WAVEGUIDES INTO PRINTED CIRCUIT BOARDS (PCB)" PROCEEDINGS. MICRO. TEC. VDE WORLD MICROTECHNOLOGIES CONGRESS, PROCEEDINGS OF INTERNATIONAL CONFERENCE ON MICROTECHNOLOGIES, XX, XX, 25. September 2000 (2000-09-25), Seiten 111-113, XP001035010 in der Anmeldung erwähnt
- LEHMACHER S.; NEYER A.; MEDERER F.: 'Polymer optical waveguides integrated in printed circuit boards' PROCEEEDINGS, 27TH CONF. ON OPT. COMMUNICATIONS (ECOC'01) 01 Oktober 2001 - 03 Oktober 2001, AMSTERDAM, Seiten 302 - 303, XP010583394

## Beschreibung

Die Erfindung betrifft ein Verfahren zur Herstellung einer elektrisch-optischen Leiterplatte gemäß Oberbegriff des Anspruches 1 sowie eine Verwendung einer derartigen Leiterplatte gemäß Oberbegriff des Anspruches 30.

Die zunehmende Taktrate von Prozessoren und die damit einhergehende Steigerung der Datenrate auf Computerboards stellt eine wachsende Herausforderung an die elektrische Verbindungstechnik dar. Insbesondere ist die Signalintegrität bei Datenraten im Bereich von Multibit pro Sekunde bis zu Gigabit pro Sekunde nur unter großen technischen und finanziellen Aufwendungen zu gewährleisten. Der Grund liegt in der Antennenwirkung elektrischer Leitungen im Hochfrequenzbereich, sowohl hinsichtlich der Sendewirkung als auch hinsichtlich der Empfangswirkung.

Aus diesem Grund werden seit Jahren optische Verbindungstechniken diskutiert und untersucht, da Lichtleiter keine Antennenwirkung selbst bei Datenraten bis in den Bereich von Terabit pro Sekunde zeigen. Das technische Problem, welches es zur Realisierung einer optischen Verbindungstechnik zwischen elektrisch arbeitenden Modulen (Prozessoren) zu lösen gilt, ist die Integration von optischen und elektrischen Leitungsmedien in einer gemeinsamen Baugruppe.

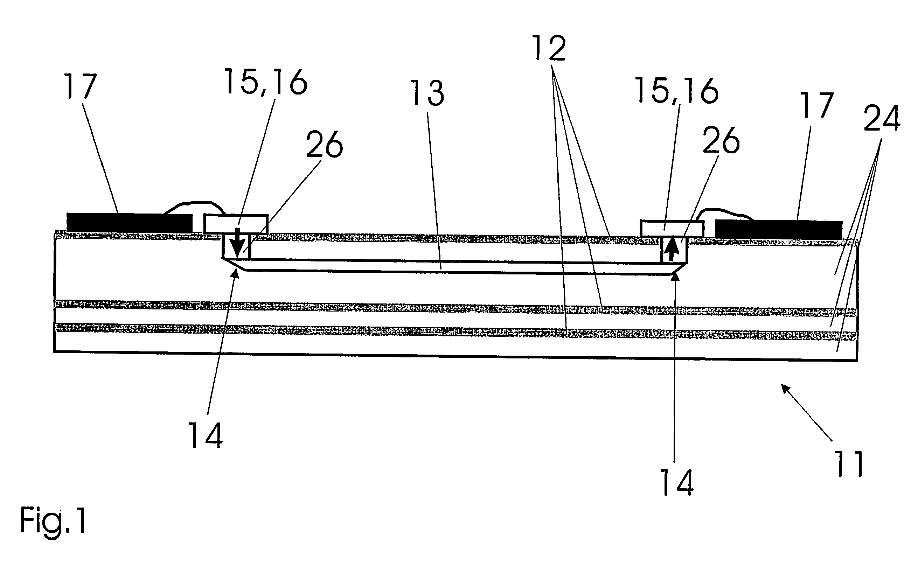

Für einen industriellen Einsatz stellt die sog. elektrisch-optische Leiterplatte (EOLP) eine bevorzugte Lösung dar. Sie besteht z.B. aus einer konventionellen Multilayer-platine, in der den elektrischen Lagen eine optische Lage hinzugefügt wird. Die Einund Auskopplung der Lichtsignale in die optische Lage kann z.B. durch Mikrospiegel erfolgen, die sich an den Enden der Wellenleiter befinden. In Fig. 1 ist eine solche elektrisch-optische Leiterplatte schematisch darstellt.

In der Publikation "S. Lehmacher, A. Neyer "Integration of polymer optical waveguides into printed circuit boards (PCB)", Proceedings MICRO.tec 2000, vol. 1, Hannover, Sept. 2000, pp. 111-113 " wird eine solche EOLP beschrieben. Dabei wird die optische Lage durch Heißprägetechniken in thermoplastischen Materialien wie z.B. Polycarbonat (PC) oder Cycloolefincopolymer (COC) hergestellt. Die optische Lage übersteht in der Regel die Einlamination in eine Multilayerplatine bei Temperaturen um 160°C ohne signifikante Zusatzverluste. Die hohen Temperatureinwirkungen beim für die industrielle Herstellung erforderlichen Reflow-Löten von ca. 230°C während einiger Minuten führen jedoch zu so erheblicher Degradation der optischen Polymere, daß eine weitere sinnvolle Verwendung der Multilayerplatine nicht mehr möglich ist. Ähnliche Konzepte, die auch auf Heißprägeverfahren unter Verwendung von thermoplastischen Materialien basieren, wurden bzw. werden in öffentlich geförderten Projekten (BMBF - Bundesministerium für Bildung und Forschung) "EOCB", "OPTOSYS" und "OPTICON" verfolgt mit dem Ergebnis, daß die verwendeten thermoplastischen Materialien keine für die Leiterplattenintegration ausreichende Temperaturstabilität besitzen. Im BMBF-Projekt "MOES" werden photostrukturierbare Epoxydharze als Wellenleitermaterial verwendet. Neben den Schwierigkeiten, Koppelspiegel zur Einleitung der optischen Signale in und aus der optischen Schicht herzustellen, zeigen sich auch hier Stabilitätsprobleme bei Temperaturen oberhalb von 200°C.

Die Verwendung der bekannten Heißprägetechniken zur Herstellung von optischen Lagen haben weiterhin den Nachteil, daß durch die einwirkenden Temperaturen und den notwendigen Druck keine besonders guten optischen Eigenschaften der dergestalt erzeugten optischen Lagen erreichbar sind. Zwar lassen die bei den Heißprägetechniken verwendeten lichthärtenden Materialien eine Wellenleiterstrukturierung durch Fotoprozesse oder Ätzprozesse zu, eine einfache Herstellung der zur Einleitung und Ausleitung des Lichtes in die optische Lage benötigten Koppelspiegel ist hierbei jedoch nicht möglich. Mittels Abformtechniken lassen sich andererseits bei thermoplastischen Materialien zwar Wellenleiter mit Umlenkspiegeln an ihren Enden herstellen, diese sind jedoch aufgrund der in der Regel niedrigen Glastemeperaturen der erforderlichen Lödbadtemperaturen nicht gewachsen.

In der US-Patentanmeldung US2003/0006068 A1 "System and method for integrating optical layers in a PCB for inter-board communications" wird ein Verfahren zur Herstellung einer EOLP beschrieben, welches auf der Lamination von optisch transparenten Polymerfolien unterschiedlicher Brechungsindizes basiert, die durch Laserablation strukturiert werden. Als bevorzugtes Polymer wird das kommerzielle Polyguide-System angegeben.

Die Nachteile dieses Verfahrens sind:
- Das Polyguide-System ist Acrylat-basiert und besitzt daher eine für Lötbadanwendungen nicht ausreichende Temperaturfestigkeit.
- Die Strukturierung durch Laserablation verursacht prozeßbedingt Rauheiten an den Wellenleiterwänden, die zu erhöhten Verlusten führen. Über Ergebnisse dieses Prozesses wird nicht berichtet.
- Die Strukturierung der Wellenleiter durch Ablation erfolgt seriell und ist daher sehr zeit- und kostenintensiv.
- Die Herstellung von Ein- und Auskoppelspiegeln z.B. durch Laserablation muß seriell erfolgen, erfordert eine hohe Justagepräzision und ist daher sehr zeit- und kostenintensiv.

In der US-Patentan meldung US2003/0007745 A1 "Optically interconnecting integrated circuit chips" wird eine Anordnung beschrieben, die eine Ankopplung von lichtemittierenden und lichtdetektierenden Bauteilen in eine optische Lage in einer Leiterplatte ermöglichen soll. Über die Ausführung der optischen Lage und die Eigenschaften der verwendeten Materialsysteme werden keine Aussagen gemacht. Realisierungsbeispiele werden nicht erwähnt.

In der Literatur sind weiterhin Methoden bekannt, aus Polysiloxanmaterialien Lichtwellenleiter herzustellen (Mitsuo Usui et al., "Low-loss passive polymer optical waveguides with high environmental stability", Journal of Lightwave Technology, vol. 14, 1996, pp 2338-2343). Diese Verfahren basieren auf reaktiven Ätzprozessen (RIE) zur zweidimensionalen Definition der lateralen Wellenleitergeometrien und weisen damit die bekannten Nachteile reaktiver Ätzprozesse auf.

In DE 195 23 580-A1 wird ein Verfahren zum Herstellen einer geformten, gespritzten bzw. gegossenen, optischen Zwischenverbindung beschrieben.

In US 6 088 492-A wird ein Verfahren zur Herstellung eines optischen Wellenleiters auf Polysiloxanbasis sowie ein Hybridsubstrat beschrieben. Gießverfahren werden bei der dort beschriebenen Herstellung nicht verwendet.

Aufgabe der vorliegenden Erfindung ist es daher, ein Verfahren zur Herstellung dämpfungsarmer und höher temperaturstabiler optischer Lagen anzugeben, die für eine prozeßtaugliche Integration in Leiterplatten geeignet sind.

Die Lösung der erfindungsgemäßen Aufgabe ergibt sich hinsichtlich des Verfahrens aus den kennzeichnenden Merkmalen des Anspruches 1. Weitere vorteilhafte Ausgestaltungen der Erfindung ergeben sich aus den Unteransprüchen.

Die Erfindung hinsichtlich des Verfahrens geht aus von einem Verfahren zur Herstellung einer elektrisch-optischen Leiterplatte, die eine Anzahl Schichten mit elektrisch leitenden Elementen und mindestens eine Schicht mit optisch leitenden Elementen, insbesondere mit Wellenleitern aufweist. Eine derartiges Verfahren wird derart weiter entwickelt, daß die mindestens eine optische Lage ein Polysiloxanmaterial aufweist und die Strukturierung der Elemente der optischen Lage durch Gießtechniken erfolgt, wobei die mechanische Verbindung zwischen der optischen Lage und der mindestens einen Schicht der elektrisch leitenden Leiterplattenschichten im direkten Zusammenhang der Herstellung der optischen Lage vorgenommen wird. Die Verwendung von Polysiloxanmaterialien zur Herstellung der optischen Lage für die Integration in Leiterplatten erlaubt eine Temperaturstabilität bis weit über 200°C und derartige optische Lagen sind kurzzeitig sogar bis 300°C belastbar. Unter dem Begriff Polysiloxan soll im weiteren die gesamte entsprechende Materialklasse aus Silikonpolymeren verstanden werden, die hinsichtlich Temperaturstabilität und optischer Eigenschaften entsprechend gleichartige oder vergleichbare Eigenschaften aufweisen. Damit eignet sich dieses Materialsystem hervorragend für den Einsatz in Reflow-Lötprozessen, die bei einer zukünftigen bleifreien Zusammensetzung der Lötbäder Temperaturen von nahezu 300°C erfordern werden. Aktuell liegt die Temperaturbelastung in Reflow-Lötbädern bei ca. 230°C. Es ist kein anderes Polymer-Materialsystem mit solchen Eigenschaften bekannt. Die erfindungsgemäße Gießtechnik zur Realisierung insbesondere von Polysiloxanwellenleitern bietet weiterhin erstmals die Möglichkeit einer einfachen dreidimensionalen Strukturierung der optischen Lage, die für eine parallele Herstellung aller Wellenleiterstrukturen insbesondere auch mit integrierten Koppelspiegeln (z.B. mit 45°-Flanken) und damit für eine ökonomische Herstellung von derartigen Leiterplatten wesentlich ist. Die im direkten zeitlichen Zusammenhang mit der gießtechnischen Herstellung der optischen Lagen erfolgende Verbindung der optischen Lage mit zumindest einer Schicht der elektrisch leitenden Leiterplattenschichten erlaubt darüber hinaus eine wesentliche Verbesserung des Handlings der optischen Lage, die üblicherweise sehr dünn im Bereich von nur 100 - 200 µm ausgebildet und damit mechanisch sehr wenig stabil und zusätzlich elastisch ist. Dadurch ist nach der an sich schon recht schwierigen Entfernung der optischen Lage aus einer entsprechenden Herstellungsform das Handling für den weiteren Herstellungsprozeß einer Leiterplatte schwierig. Durch das Anbinden an die eine Schicht der Leiterplatte entfällt jedoch dieses Handlingsproblem weitgehend, da die Leiterplatte selbst mechanisch wesentlich stabiler als die optische Lage ausgebildet ist und daher auch einfacher gehandhabt werden kann. Die Leiterplattenschicht stabilisiert daher die optische Lage für den weiteren Herstellungsvorgang. Damit können z.B. auch Positioniervorgänge im Zuge der weiteren Fertigung zwischen optischer Schicht und der Leiterplatte selbst mit höherer Genauigkeit ausgeführt werden, wodurch bisher notwendige Justierungsvorgänge z.B. im Rahmen des Anschlusses der optischen Schicht an elektrische Bauelemente entfallen können. So kann beispielsweise die Leiterplattenschicht vor dem Ausformen der optischen Lage relativ zur Gießform der optischen Lage positioniert werden, was viel einfacher als die Positionierung z.B. relativ zu einer schon ausgeformten nachgiebigen optischen Lage selbst ist.

Von besonderem Vorteil ist es hierbei, wenn die mechanische Verbindung zwischen der optischen Lage und der mindestens einen Schicht der elektrisch leitenden Leiterplattenschichten direkt bei der Herstellung der Elemente der optischen Lage vorgenommen wird. Damit entfallen jegliche Handhabungsvorgänge der optischen Lage als eigenständiges Element im Rahmen der weiteren Fertigung der Leiterplatte, indem die optische Lage schon im Rahmen ihrer eigenen Herstellung mit der Leiterplatte verbunden werden kann. Die in-situ-Verbindung von optischer Lage und Leiterplatte verhindert jegliche Fehlerquellen wie Beschädigungen und Positionierungsfehler, die sich sonst aufgrund der schlechten Handhabbarkeit der optischen Lage als einzelnes Bauteil nicht vermeiden lassen. Damit läßt sich der Herstellungsvorgang kombiniert optisch-elektrischer Leiterplatten wesentlich verbessern und sicherer gestalten.

Eine vorteilhafte Ausgestaltung der Erfindung sieht vor, daß die optische Lage aus einem höherbrechendem Kern-Polysiloxan sowie einem niedrigbrechenden Polysiloxan als Superstratschicht und einem niedrigbrechenden Polysiloxan als Substratschicht in Form von Deckschichten auf dem Kern-Polysiloxan gebildet wird. Hierdurch können die besonderen Vorteile von Polysiloxanwerkstoffen im Hinblick auf die Temperaturstabilität und die hohe optische Güte besonders gut miteinander kombiniert werden, wenn alle die optische Lage bildenden Schichten aus derartigen Polysiloxanen gebildet sind. Die Verbindung derartig gleichartiger Materialien läßt sich dabei ebenfalls einfach herstellen, darüber hinaus ist das Temperaturverhalten ebenfalls weitgehend identisch.

In einer ersten vorteilhaften Ausgestaltung wird das Superstrat-Polysiloxan in flüssiger Form auf das schon verfestigte Kern-Polysiloxan appliziert, danach in seiner flüssigen Phase mit einer Schicht der elektrisch leitenden Leiterplattenschichten in Verbindung gebracht und anschließend vernetzt. Bei dieser Vorgehensweise wird die Superstratschicht direkt auf das Kern-Polysiloxan aufgebracht, ohne daß das Kern-Polysiloxan selbst aus der Gießform heraus genommen werden muß. In einer äquivalenten Ausgestaltung ist es aber auch denkbar, daß das Substrat-Polysiloxan in flüssiger Form auf das schon verfestigte Kern-Polysiloxan appliziert wird, in seiner flüssigen Phase mit einer Schicht der elektrisch leitenden Leiterplattenschichten in Verbindung gebracht und anschließend vernetzt wird. Damit kann wahlweise entweder die Substratschicht oder die Superstratschicht auf das Kern-Polysiloxan aufgebracht werden, je nachdem, welche Vorgehensweise für die weitere Fertigung der Leiterplatte vorteilhafter ist. Durch das Aufbringen der Schicht der Leiterplatte auf die noch flüssige Substratschicht bzw. Superstratschicht kann nach der anschließenden Vernetzung dieser Polysiloxanschicht die Schicht der elektrisch leitenden Leiterplattenschichten mechanisch sicher und ohne zusätzlichen Arbeitsgang an der Polysiloxanschicht festgelegt werden. Durch das Abdecken der aufgegossenen Superstratschicht oder der Substratschicht mit dem Leiterplattenmaterial wird die optische Lage gleichzeitig mit dem Leiterplattenmaterial fest verbunden. Eine nachträgliche Lamination bzw. Verklebung der optischen Lage mit Leiterplattenmaterial ist technisch ebenfalls möglich, dann muß jedoch ein zusätzlicher Laminations- bzw. Klebeschritt erfolgen.

Der Verbund aus Superstratschicht/Kern-Polysiloxan und der Substratschicht kann besonders vorteilhaft hergestellt werden, wenn in einem ersten Schritt Grubenstrukturen einer Gießform mit höherbrechendem Kern-Polysiloxan gefüllt und ausgehärtet werden, in einem zweiten Schritt ein niedrigbrechendes Polysiloxan als Superstratschicht so aufgebracht wird, daß sie sich mit dem Kern-Polysiloxan verbindet, in einem dritten Schritt die Superstratschicht mit den auf ihr befindlichen optisch leitenden Elementen von der Gießform getrennt werden und in einem vierten Schritt ein niedrigbrechendes Polysiloxan als Substratschicht auf das Kern-Polysiloxan aufgebracht wird. Hierbei füllt zuerst das Kern-Polysiloxan die Gießform aus und wird anschließend mit der Superstratschicht abgedeckt und anschließend nach dem Entformen des derart hergestellten Verbundes in einem getrennten Arbeitsgang die Substratschicht aufgebracht.

Denkbar ist es allerdings auch, das in einem ersten Schritt das niedrigbrechende Polysiloxan-Substrat mit Grubenstrukturen gießtechnisch hergestellt wird, in einem zweiten Schritt ein höherbrechendes Kern-Polysiloxan in die Gruben gefüllt und in einem dritten Schritt ein niedrigbrechendes Polysiloxan als Superstratschicht auf den Verbund Polysiloxan-Substrat/Kern-Polysiloxan aufgebracht wird.

Von besonderem Vorteil im Hinblick auf die Genauigkeit der Fertigung von Superstratschicht bzw. Substratschicht ist es, wenn die Schicht der elektrisch leitenden Leiterplattenschichten auf der dem flüssigen Polysiloxan der Substratschicht bzw. der Superstratschicht zugewandten Seite mikrostrukturierte Abstandshalter aufweist, die eine definierte Dicke der Substratschicht bzw. der Superstratschicht gewährleisten. Durch die Einführung von derartigen Stützstrukturen auf den Leiterplatten, die als Abstandshalter fungieren, werden sehr dünne Superstrat- und Substratschichtdicken von wenigen 10µm möglich, die bei einer freitragenden Ausführung keine ausreichende mechanische Stabilität aufweisen würden. Möglichst dünnschichtige Aufbauweisen sind aber für die Integration in Multilayerplatinen sehr vorteilhaft.

In einer anderen Ausgestaltung der Erfindung hinsichtlich der Verbindung zwischen optischer Lage und Leiterplatte ist es auch denkbar, daß die mechanische Verbindung zwischen der optischen Lage und der mindestens einen Schicht der elektrisch leitenden Leiterplattenschichten im Anschluß an die Herstellung der optischen Lage vorgenommen wird. Hierbei wird die optische Lage erst komplett oder weitgehend komplett vorgefertigt und erst dann, allerdings ohne weitere Zwischenschritte mit der Leiterplattenschicht verbunden. Dadurch wird erreicht, daß die Fertigung der optischen Lage in einem vorteilhaften Ablauf erfolgen kann und dann nach Abschluß der Arbeiten an der optischen Lage diese als Ganzes mit der Leiterplattenschicht verbunden wird. Ab diesem Zeitpunkt wird dann der Verbund aus optischer Lage und Leiterplattenschicht wieder in dem schon beschriebenen Sinne als Ganzes handhabbar. Dabei kann die optische Lage entweder einseitig oder beidseitig mit einer oder mehreren Schichten der elektrisch leitenden Leiterplattenschichten mechanisch in Verbindung gebracht werden. Die Herstellung einer Verbindung der optischen Lage mit einer Schicht der elektrisch leitenden Leiterplattenschichten kann in grundsätzlich bekannter Weise durch Lamination oder Verklebung erfolgen.

Eine besonders gute Verbindung zwischen Leiterplattenschicht und optischer Lage läßt sich dann erreichen, wenn zur Unterstützung der Verbindung des Polysiloxans der optischen Lage mit der Schicht der elektrisch leitenden Leiterplattenschichten Haftvermittler eingesetzt werden. Hierbei ist zu beachten, daß als Haftvermittler nur Substanzen eingesetzt werden dürfen, die die optische Lage auch auf Dauer nicht angreifen oder deren optische Eigenschaften beeinträchtigen. So ist es z.B. denkbar, daß als Haftvermittler eine gut auf der Schicht der elektrisch leitenden Leiterplattenschichten haftende Polymerschicht auf die optische Lage aufgebracht wird, die zum einen eine sichere Haftung auf beiden Verbindungspartnern aufweist und chemisch neutral gegenüber den Verbindungspartnem ist.

In einer anderen Ausgestaltung zur Verbesserung der Haftung zwischen Leiterplattenschicht und optischer Lage ist es auch denkbar, daß eine physikalische und/oder chemische Behandlung der Oberfläche der Schicht der elektrisch leitenden Leiterplattenschichten vorgenommen wird, die mit der optischen Lage verbunden wird, um eine Aktivierung der Oberfläche zur verbesserten Haftung mit der optischen Lage zu erreichen. Eine derartige Behandlung, die beispielsweise mittels Beflammung mit Gasen oder auch mittels Plasmabestrahlung durchgeführt werden kann und die Oberfläche der Leiterplattenschicht in ihren Hafteigenschaften bezüglich der optischen Lage positiv beeinflußt, führt zur chemischen und/oder physikalischen Aktivierung der Oberfläche und damit zu einer verbesserten Haftung.

Von wesentlichem Vorteil für die Herstellung der elektrisch-optischen Leiterplatte ist es, wenn die Gießtechniken zur Strukturierung der optisch leitenden Elemente im wesentlichen bei Umgebungstemperaturen ausgeführt werden. Hierdurch kann ohne die sonst notwendige Erhitzung der Materialien wie etwa bei dem bekannten Heißprägen und ohne die damit einhergehenden Materialbeeinflussungen gearbeitet werden, auch läßt sich ein Verzug der optischen Lage aufgrund Temperaturdehnungen oder chemischen Veränderungen sicher vermeiden. Vorteilhaft ist es hierbei auch, daß beim Gießen der optisch leitenden Elemente die Oberfläche der gegossenen optisch leitenden Elemente durch Rakeln abgezogen und damit die Gießform vollständig gefüllt wird. Es bildet sich damit immer eine gleichbleibend gute Abformung der Gießform auf die optische Lage und damit lassen sich gleichbleibende optische Eigenschaften der optischen Lage erzielen. Durch die Gießtechniken zur Strukturierung der optisch leitenden Elemente können auch großflächige Strukturen der optisch leitenden Elemente hergestellt werden. Damit können beispielsweise Wellenleiter auch mit sehr großen Querschnitten - wie z.B. 1 mm x 1 mm - sowie Wellenleiter mit großen Längserstreckungen auf einfache Weise hergestellt werden können. Derartig große Strukturen z.B. in LIGA-Technik herzustellen ist nicht wirtschaftlich möglich.

Eine besonders vorteilhafte Wirkung des erfindungsgemäß verwendeten Polysiloxanmaterials läßt sich insofern erzielen, daß das Polysiloxanmaterial aufgrund seiner elastischen Eigenschaften auch aus gießtechnischen Vertiefungen mit sehr steilen Wandungen oder Vertiefungen mit Hinterschnitten ohne Beeinträchtigungen ausformbar ist. Die zur Herstellung der Gießformen mittels lithographischer Verfahren häufig verwendeten Dicklackstrukturen wie etwa der Lack Negativresist SU/8 weisen zwar eine besonders gute Oberflächenqualität auf, bilden jedoch aufgrund unterschiedlicher Schrumpfungsprozesse häufig Hinterschneidungen innerhalb der Gießform, die ein Entformen der mechanisch sehr wenig stabilen optischen Lage erschweren oder unmöglich machen. Dies beruht vermutlich auf unterschiedlichen Vernetzungen innerhalb des Lackes bei der Aushärtung unter Lichteinfluß. Derartige Hinterschneidungen führen beim Ausformen sonst häufig benutzter recht starrer Materialien für optischen Lagen dazu, daß entweder die optischen Lagen beschädigt oder sogar unbrauchbar werden oder aber die Gießform beschädigt wird und damit nur einmal benutzt werden kann. Aufgrund der Elastizität des Polysiloxans lassen sich hieraus hergestellte optische Lagen auch bei Vorliegen von Hinterschneidungen der Gießform unproblematisch ausformen, da durch die Elastizität eine entsprechende nicht-zerstörende Verformung des Polysiloxans möglich ist.

Von weiterem Vorteil ist es, wenn die Koppelelemente zur optischen Ankopplung der optisch leitenden Elemente an funktional zu verbindende elektrisch leitende Elemente der elektrisch leitenden Leiterplattenschichten gleichzeitig beim Gießen der Schicht mit den optisch leitenden Elementen hergestellt werden. Hierfür können beispielsweise die Gießformen für die optisch leitenden Elemente an den Enden, vorzugsweise unter 45°, abgeschrägte Flanken besitzen, durch diese Flanken in der optischen Lage angeformte Abschnitte der optischen Lage nach der Entformung lokal metallisiert werden und dann die Funktion von integrierten Umlenkspiegeln besitzen. Damit ist eine in die Herstellung der optischen Lage integrierte Fertigung derartiger Koppelelemente möglich, die Justierungsoperationen separat gefertigter Koppelelemente und damit unvermeidliche Fehler oder hohen Kostenaufwand vermeiden.

Hinsichtlich der Ausgestaltung der Elemente der optischen Lage ist es von Vorteil, wenn die optisch leitenden Elemente der optischen Lage Kreuzungen, Verzweigungen, Mischer, Wellenlängenmultiplexer und Wellenlängendemultiplexer und Schaltelemente enthalten. Damit und natürlich auch mit sonstigen, bekannten optisch leitenden Elementen können weitgehend alle geforderten Eigenschaften der optischen Lage aufgebaut werden, die für den Einsatz in Multilayerplatinen notwendig sind.

Von der Erfindung ebenfalls mit umfaßt ist die Verwendung einer optisch-elektrischen Leiterplatte, bei der auf einer oder auf beiden Seiten des verfahrensmäßig hergestellten Verbundes aus optischer Lage und mit der optischen Lage verbundenen Schichten der Leiterplatte weitere Schichten der Leiterplatte oder weitere Leiterplatten zu einem Multilayer-Verbund hinzugefügt werden. Damit können auch komplexe Schaltungsdesigns realisiert werden, die anwendungsspezifisch ausgelegt werden können. Eine andere Art der Verwendung der optisch-elektrischen Leiterplatte kann darin bestehen, daß der verfahrensmäßig hergestellte Verbund aus optischer Lage und mit der optischen Lage verbundenen Schichten der Leiterplatte auf ein steifes oder auch auf ein flexibles Trägermedium aufgebracht wird. Damit kann das Trägermedium ebenfalls dem Einsatzzweck angepaßt werden.

Das erfindungsgemäße Verfahren kann, dargestellt noch einmal anhand eines geschlossenen, allerdings nur als ein denkbares Beispiel angeführten Verfahrensablaufs, folgende Schritte umfassen:

Ausgangspunkt ist eine geeignete Gießform, in der die Wellenleiterstrukturen als Gruben vorliegen und die Grubenenden mit 45°-Schrägen versehen sind. Solche Gießformen können mit Hilfe verschiedener Mikrotechnologien, wie z.B. Mikroätztechniken in Silizium, LIGA-Technik, UV-Lithographie oder durch mikromechanische Bearbeitungsverfahren hergestellt werden. Die Gruben der Gießform werden anschließend mit einem flüssigen, höherbrechenden Silkonpolymer der Brechzahl n₂ aufgefüllt. Bei dem Befüllen ist darauf zu achten, daß kein Restfilm einer Dicke größer als 1 µm in den Bereichen neben den Wellenleitergruben verbleibt. Bevorzugte Technologie zur präzisen Befüllung der Gruben ist hierbei die Rakeltechnik, mit der eine besonders gute Befüllung der Wellenleitergruben ermöglicht wird. Nach dem Befüllen folgt die Vernetzung des Polysiloxanpolymers. Das in den Gruben ausgehärtete Material bildet das Kernpolymer der herzustellenden Lichtwellenleiter.

Anschließend wird die Gießform mit den ausgehärteten Lichtleiterkernen mit einem niedrigbrechenden Polysiloxanpolymer der Brechzahl n₁ (n₁ < n₂) übergossen und mit einer Platte aus Leiterplattenmaterial abgedeckt. Das Leiterplattenmaterial besitzt auf der der Gießform zugewandten Seite mechanische Stützstrukturen, die als Abstandshalter fungieren und bei einem Preßvorgang des Leiterplattenmaterials gegen die Gießform eine definierte Dicke der herzustellenden Schicht (Superstrat) garantieren. Dabei ist zu gewährleisten, daß die Stützstrukturen neben den Wellenleiterstrukturen angebracht sind und keinen Kontakt mit den Wellenleitern besitzen. Die Stützstrukturen können durch mechanische Verfahren, vorzugsweise jedoch durch strukturiertes Ätzen einer entsprechend dicken Kupferschicht hergestellt werden. Zusätzlich wird das Leiterplattenmaterial in den Bereichen, unter denen sich Koppelspiegel befinden, freigestellt. Nach dem Preßvorgang wird das Superstrat-Polymer vernetzt.

Die verwendeten Leiterplatten können entweder aus glasfaserverstärktem Epoxydharz bestehen, wie z.B. FR4, oder aus Kapton, Teflon, Glas oder anderen geeigneten dielektrischen Trägermaterialien. Die Leiterplatten können entweder gänzlich ohne elektrisch leitfähige Schicht, mit einer einseitigen oder auch zweiseitigen leitfähigen Schicht versehen sein. Die elektrisch leitfähigen Schichten können entweder gar nicht oder einseitig oder zweiseitig als elektrische Leiterbahnen strukturiert sein.

Der derart hergestellte Verbund Wellenleiterkern/Superstrat/Leiterplattenmaterial wird nun von der Gießform getrennt. Die freigelegten 45°-Schrägen an den Wellenleiterenden werden mit Hilfe einer Schattenmaskentechnik lokal metallisiert und haben anschließend die Funktion integrierter Koppelspiegel.

Die Wellenleiterkernschicht wird dann mit einem niedrigbrechenden Polysiloxanpolymer der Brechzahl n₃ (n₃ < n₂) übergossen, welche die Wellenleiter-Substratschicht bildet und vorzugsweise dieselbe Brechzahl n₁ wie das Superstrat besitzt. Die noch flüssige Substratpolymerschicht wird ebenfalls mit einer Schicht aus Leiterplattenmaterial abgedeckt, welche mechanische Stützstrukturen enthält, die als Abstandshalter fungieren und nach einem Preßvorgang eine definierte Substratschichtdicke garantieren.

Alternativ zu diesem vorstehend beschriebenen Verfahren kann im ersten Schritt auch ein niedrigbrechendes Polysiloxansubstrat mit Wellenleitergruben erstellt werden, welches während der Herstellung mit einem Leiterplattenmaterial verbunden wird. Im zweiten Schritt werden die Gräben mit höherbrechendem Polysiloxanmaterial gefüllt, wobei wiederum die Rakeltechnik zu bevorzugen ist. Im letzten Schritt wird der Verbund Leiterplatte/Wellenleitersubstrat/Wellenleiterkern mit einer niedrigbrechenden Polysiloxanschicht, dem Superstrat, überzogen und - wie vorstehend erwähnt - während der flüssigen Phase mit Leiterplattenmaterial abgedeckt.

Beide Verfahren führen zum Ergebnis einer optischen Lage aus Polysiloxan, die in eine Leiterplatte integriert ist. Vorzugsweise ist jedoch das erste Verfahren zu verwenden, da das zweite Verfahren die Einschränkung aufweist, daß beim Grubenfüllvorgang auf dem relativ weichen Polysiloxansubstrat gerakelt werden muß. Dabei drückt die Rakel die Substratoberfläche ein, was zu einer unvollständigen Füllung der Gruben führen kann. Das wiederum führt zu geometrischen Schwankungen der Lichtleiterquerschnitte und damit zu erhöhten Wellenleiterverlusten.

Eine besonders bevorzugte Ausführungsform des erfindungsgemäßen Verfahrens zeigt die Zeichnung.

Es zeigen:
- Figur 1: - den grundsätzlich aus dem Stand der Technik bekannten Aufbau einer optisch-elektrischen Leiterplatte,
- Figur 2: - den Ablauf eines beispielhaft und vereinfacht dargestellten Verfah- rensablaufs gemäß der vorliegenden Erfindung.

In Fig. 1 ist der schematische Aufbau einer an sich bekannten elektrisch-optischen Leiterplatte (EOLP) dargestellt. Dabei wird in eine Multilayerplatine 11 neben den Lagen 24 mit elektrischen Leiterbahnen 12 eine optische Lage 13 eingefügt. Diese hat hier die Funktion einer optischen Verbindung zwischen zwei Prozessoren 17. Die elektrischen Signale der Prozessoren 17 werden durch elektro-optische Wandler bzw. Sender 15 in optische Signale überführt, durch entsprechende Öffnungen 10 in die Multilayerplatine 11 geleitet, dort durch Umlenkspiegel 14 in die optische Lage 13 eingekoppelt, am Ende über Umlenk- bzw. Koppelspiegel 14 wieder aus der optischen Lage 13 ausgekoppelt und einem elektro-optischen Wandler bzw. Empfänger 16 zugeführt. Dieser liefert dem jeweils adressierten Prozessor 17 die von ihm verwertbaren elektrischen Signale. Problematisch bei der Herstellung einer derartigen elektrisch-optischen Leiterplatte 11 ist die Herstellung und Einbindung der optischen Lage 13 in den Verbund der Schichten der Multilayerplatine 11.

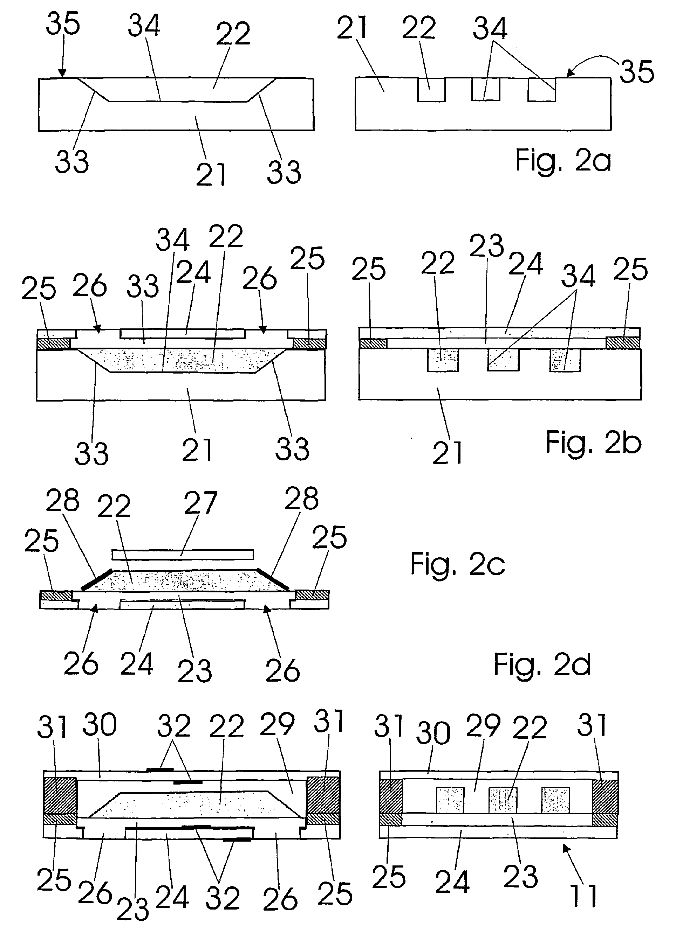

In Fig. 2 ist der Herstellungsablauf für die Herstellung der optischen Lage 13 und der darin angeordneten Polysiloxanwellenleiter 22 gemäß der vorliegenden Erfindung durch Gießtechnik und die Integration in eine Leiterplatte 11 dargestellt.

Fig. 2a zeigt eine geeignete Gießform 21, in der die Wellenleiterstrukturen als Negativform in Form von Gruben 34 vorliegen und die Grubenenden 33 mit 45°-Schrägen versehen sind. Solche Gießformen 21 können mit Hilfe verschiedener Mikrotechnologien, wie z.B. Mikroätztechniken in Silizium, LIGA-Technik, UV-Lithographie oder durch mikromechanische Bearbeitungsverfahren hergestellt werden. Die Gruben 34 werden präzise bis zur Oberkante 35 mit einem flüssigen, höherbrechenden Silkonpolymer 22 der Brechzahl n₂ aufgefüllt. Nach dem Befüllen folgt die Vernetzung des Polysiloxanpolymers 22. Das in den Gruben 34 ausgehärtete Silkonpolymer 22 bildet das Kernpolymer der herzustellenden Lichtwellenleiter.

In Fig. 2b ist die Gießform 21 mit den ausgehärteten Lichtwellenleiterkernen 22 mit einem niedrigbrechenden Polysiloxanpolymer 23 der Brechzahl n₁ (n₁ < n₂) übergossen und mit einer Platte 24 aus Leiterplattenmaterial abgedeckt. Das Leiterplattenmaterial 24 besitzt auf der der Gießform 21 zugewandten Seite mechanische Stützstrukturen 25, die als Abstandshalter fungieren. Bei einem nicht dargestellten Preßvorgang wird das Leiterplattenmaterial 24 gegen die Gießform 21 gepreßt und garantiert dabei eine definierte Dicke der herzustellenden Schicht 23 des so gebildeten Superstrats. Durch die Positionierung der Stützstrukturen 25 wird gewährleistet, daß diese neben den Wellenleiterstrukturen 22 angebracht sind und nicht mit ihnen in Kontakt kommen. Die Stützstrukturen 25 können z.B. durch strukturiertes Ätzen einer entsprechend dicken Kupferschicht hergestellt werden.

Zusätzlich wird das Leiterplattenmaterial 24 in den Bereichen, unter denen sich Koppelspiegel 33 befinden, mit Öffnungen 26 freigestellt. Nach dem Pressvorgang wird das Superstrat-Polymer 23 vernetzt.

In Fig. 2c ist der Verbund Wellenleiterkern/Superstrat/Leiterplattenmaterial 22, 23, 24 gezeigt, nachdem er von der Gießform 21 getrennt wurde. Weiterhin wird gezeigt, wie die freigelegten 45°-Schrägen an den Wellenleiterenden 33 mit Hilfe einer Schattenmaske 27 lokal metallisiert 28 werden. Nach diesem Technologieschritt haben sie die Funktion integrierter Koppelspiegel.

In Fig. 2d ist die Wellenleiterkernschicht 22 gezeigt, nachdem sie mit einem niedrigbrechenden Polysiloxanpolymer 29 der Brechzahl n₃ (n₃ < n₂) übergossen wurde. Diese Schicht bildet die Wellenleiter-Substratschicht 29 und besitzt vorzugsweise dieselbe Brechzahl n₁ wie das Superstrat 23. Die noch flüssige Substratpolymerschicht 29 wird ebenfalls mit einer Platte 30 aus Leiterplattenmaterial abgedeckt, welche mechanische Stützstrukturen 31 enthält, die als Abstandshalter fungieren und nach einem Preßvorgang eine definierte Substratdicke garantiert.

Die in Fig. 2d gezeigte Struktur stellt eine elektrisch-optische Leiterplatte 11 dar, wobei die beiden Leiterplatten 24, 30 auf den Außenseiten mit nicht weiter dargestellten elektrischen Bauteilen bestückt werden können. Elektrische Leiterbahnen 32 können auf beiden Seiten der Leiterplatten 24, 30 angebracht werden. Vorzugsweise wird die in Abb. 2d gezeigte Struktur jedoch in eine Multilayer-Platine 11 eingebunden.

Als Leiterplattenmaterialien wird vorzugsweise das Standard-Platinenmaterial FR4 eingesetzt. Für die Einbettung der optischen Lage 13 sind aber auch Materialien wie z.B. Aluminium, Kupfer, Teflon, Kapton und auch Glas möglich.

### Sachnummernliste

- 11: - Multilayerplatine/elektrisch-optische Leiterplatte
- 12: - Leiterbahn
- 13: - optische Lage
- 14: - Umlenkspiegel/Koppelelement
- 15: - Sender
- 16: - Empfänger
- 17: - Prozessor
- 21: - Gießform
- 22: - Wellenleiter/Kern-Polysiloxanschicht/optisch leitendes Element
- 23: - Superstratschicht
- 24: - Leiterplatte
- 25: - Stützelement
- 26: - Durchbruch/Öffnung
- 27: - Schattenmaske
- 28: - metallisierte Auflage
- 29: - Substratschicht
- 30: - Leiterplatte
- 31: - Stützelement
- 32: - Leiterbahn
- 33: - abgeschrägter Endbereich
- 34: - Grube

## Patentansprüche

1. Verfahren zur Herstellung einer elektrisch-optischen Leiterplatte (11), aufweisend eine Anzahl Schichten (24, 30) mit elektrisch leitenden Elementen (12) und mindestens eine optische Lage (13) mit optisch leitenden Elementen (22), insbesondere mit Wellenleitern (22), wobei die Strukturierung der Elemente (22) der optischen Lage (13) durch Gießen in eine die Wellenleiterstrukturen als Negativform beinhaltende Gießform (21) erfolgt, wobei die mechanische Verbindung zwischen der optischen Lage (13) und der mindestens einen Schicht (24, 30) der elektrisch leitenden Leiterplattenschichten im direkten Zusammenhang der Herstellung der optischen Lage (13) vorgenommen wird, **dadurch gekennzeichnet, daß**
die mindestens eine optische Lage (13) ein Polysiloxanmaterial aufweist und in einem ersten Schritt Grubenstrukturen (34) einer Gießform (21) mit höherbrechendem Kern-Polysiloxan (22) gefüllt und ausgehärtet werden und anschließend ein niedrigbrechendes Polysiloxan als Superstratschicht (23) und/oder als Substratschicht (29) auf zumindest das Kern-Polysiloxan (22) aufgegossen wird und sich mit dem Kern-Polysiloxan (22) verbindet.

2. Verfahren gemäß Anspruch 1, **dadurch gekennzeichnet, daß** die mechanische Verbindung zwischen der optischen Lage (13) und der mindestens einen Schicht (24, 30) der elektrisch leitenden Leiterplattenschichten direkt bei der Herstellung der Elemente (22) der optischen Lage (13) vorgenommen wird.

3. Verfahren gemäß Anspruch 2, **dadurch gekennzeichnet, daß** die optische Lage (13) aus einem höherbrechendem Kern-Polysiloxan (22) sowie einem niedrigbrechenden Polysiloxan als Superstratschicht (23) und einem niedrigbrechenden Polysiloxan als Substratschicht (29) in Form von Deckschichten auf dem Kern-Polysiloxan (22) gebildet wird.

4. Verfahren gemäß Anspruch 3, **dadurch gekennzeichnet, daß** das Superstrat-Polysiloxan (23) in flüssiger Form auf das schon verfestigte Kern-Polysiloxan (22) appliziert wird, in seiner flüssigen Phase mit einer Schicht (24, 30) der elektrisch leitenden Leiterplattenschichten in Verbindung gebracht und anschließend vernetzt wird.

5. Verfahren gemäß Anspruch 3, **dadurch gekennzeichnet, daß** das Substrat-Polysiloxan (29) in flüssiger Form auf das schon verfestigte Kern-Polysiloxan (22) appliziert wird, in seiner flüssigen Phase mit einer Schicht (30) der elektrisch leitenden Leiterplattenschichten in Verbindung gebracht und anschließend vernetzt wird.

6. Verfahren gemäß einem der Ansprüche 4 oder 5, **dadurch gekennzeichnet, daß** nach der Vernetzung der Polysiloxanschicht des Substrates (29) oder des Superstrates (23) die eine Schicht (24) der elektrisch leitenden Leiterplattenschichten mechanisch an der Polysiloxanschicht (23, 29) festgelegt ist.

7. Verfahren gemäß einem der Ansprüche 3 bis 6, **dadurch gekennzeichnet, daß** in einem ersten Schritt Grubenstrukturen (34) einer Gießform (21) mit höherbrechendem Kern-Polysiloxan (22) gefüllt und ausgehärtet werden, in einem zweiten Schritt ein niedrigbrechendes Polysiloxan als Superstratschicht (23) so aufgebracht wird, daß sie sich mit dem Kern-Polysiloxan (22) verbindet, in einem dritten Schritt die Superstratschicht (23) mit den auf ihr befindlichen optisch leitenden Elementen (22) von der Gießform (21) getrennt werden und in einem vierten Schritt ein niedrigbrechendes Polysiloxan als Substratschicht (29) auf das Kern-Polysiloxan (22) aufgebracht wird.

8. Verfahren gemäß einem der Ansprüche 3 bis 6, **dadurch gekennzeichnet, daß** in einem ersten Schritt das niedrigbrechende Polysiloxan-Substrat (29) mit Grubenstrukturen (34) gießtechnisch hergestellt wird, in einem zweiten Schritt ein höherbrechendes Kern-Polysiloxan (22) in die Gruben (34) gefüllt und in einem dritten Schritt ein niedrigbrechendes Polysiloxan als Superstratschicht (23) auf den Verbund Polysiloxan-Substrat/Kern-Polysiloxan (29, 22) aufgebracht wird.

9. Verfahren gemäß einem der Ansprüche 3 bis 8, **dadurch gekennzeichnet, daß** die Schicht (24, 30) der elektrisch leitenden Leiterplattenschichten auf der dem flüssigen Polysiloxan der Substratschicht (29) bzw. der Superstratschicht (23) zugewandten Seite mikrostrukturierte Abstandshalter (25, 31) aufweist, die eine definierte Dicke der Substratschicht (29) bzw. der Superstratschicht (23) gewährleisten.

10. Verfahren gemäß Anspruch 1, **dadurch gekennzeichnet, daß** die mechanische Verbindung zwischen der optischen Lage (13) und der mindestens einen Schicht (24, 30) der elektrisch leitenden Leiterplattenschichten im Anschluß an die Herstellung der optischen Lage (13) vorgenommen wird.

11. Verfahren gemäß Anspruch 10, **dadurch gekennzeichnet, daß** die optische Lage (13), bestehend aus Polysiloxan-Substrat, (29) und/oder Polysiloxan-Kern (22) und/oder Polysiloxan-Superstrat (23) zunächst als eigenständige Lage hergestellt und anschließend entweder einseitig oder beidseitig mit einer oder mehreren Schichten (24, 30) der elektrisch leitenden Leiterplattenschichten mechanisch in Verbindung gebracht wird.

12. Verfahren gemäß Anspruch 11, **dadurch gekennzeichnet, daß** die Verbindung der optischen Lage (13) mit einer Schicht (24, 30) der elektrisch leitenden Leiterplattenschichten durch Lamination oder Verklebung erfolgt.

13. Verfahren gemäß einem der vorstehenden Ansprüche, **dadurch gekennzeichnet, daß** die optisch leitende Schicht (22) während der Herstellung der elektrisch-optischen Leiterplatte (11) gemeinsam mit der mindestens einen Schicht (24, 30) der elektrisch leitenden Leiterplattenschichten gehandhabt wird.

14. Verfahren gemäß einem der vorstehenden Ansprüche, **dadurch gekennzeichnet, daß** zur Unterstützung der Verbindung des Polysiloxans der optischen Lage (13) mit der Schicht (24, 30) der elektrisch leitenden Leiterplattenschichten Haftvermittler eingesetzt werden.

15. Verfahren gemäß Anspruch 14, **dadurch gekennzeichnet, daß** als Haftvermittler eine gut auf der Schicht (24, 30) der elektrisch leitenden Leiterplattenschichten haftende Polymerschicht auf die optische Lage (13) aufgebracht wird.

16. Verfahren gemäß einem der Ansprüche 1 bis 13, **dadurch gekennzeichnet, daß** eine physikalische und/oder chemische Behandlung der Oberfläche der Schicht (24, 30) der elektrisch leitenden Leiterplattenschichten vorgenommen wird, die mit der optischen Lage (13) verbunden wird, um eine Aktivierung der Oberfläche zur verbesserten Haftung mit der optischen Lage (13) zu erreichen.

17. Verfahren gemäß Anspruch 16, **dadurch gekennzeichnet, daß** die Schicht (24, 30) der elektrisch leitenden Leiterplattenschichten, die mechanisch mit der optischen Lage (13) verbunden wird, mittels Beflammung mit Gasen in ihren Hafteigenschaften bezüglich der optischen Lage (13) beeinflußt wird.

18. Verfahren gemäß Anspruch 16, **dadurch gekennzeichnet, daß** die Schicht (24, 30) der elektrisch leitenden Leiterplattenschichten, die mechanisch mit der optischen Lage (13) verbunden wird, mittels Plasmabestrahlung in ihren Hafteigenschaften bezüglich der optischen Lage (13) beeinflußt wird.

19. Verfahren gemäß einem der vorstehenden Ansprüche, **dadurch gekennzeichnet, daß** die Gießtechniken zur Strukturierung der optisch leitenden Elemente (22) im wesentlichen bei Umgebungstemperaturen ausgeführt werden.

20. Verfahren gemäß einem der vorstehenden Ansprüche, **dadurch gekennzeichnet, daß** beim Gießen der optisch leitenden Elemente (22) die Oberfläche der gegossenen optisch leitenden Elemente (22) durch Rakeln abgezogen und damit die Gießform (21) vollständig gefüllt wird.

21. Verfahren gemäß einem der vorstehenden Ansprüche, **dadurch gekennzeichnet, daß** durch die Gießtechniken zur Strukturierung der optisch leitenden Elemente (22) auch großflächige Strukturen der optisch leitenden Elemente (22) hergestellt werden können.

22. Verfahren gemäß einem der vorstehenden Ansprüche, **dadurch gekennzeichnet, daß** das Polysiloxanmaterial aufgrund seiner elastischen Eigenschaften auch aus gießtechnischen Vertiefungen (34) mit sehr steilen Wandungen oder Vertiefungen mit Hinterschnitten ohne Beeinträchtigungen ausformbar ist.

23. Verfahren gemäß einem der vorstehenden Ansprüche, **dadurch gekennzeichnet, daß** die Koppelelemente (14) zur optischen Ankopplung der optisch leitenden Elemente (22) an funktional zu verbindende elektrisch leitende Elemente (15, 16, 17) der elektrisch leitenden Leiterplattenschichten (12) gleichzeitig beim Gießen der optischen Lage (13) mit den optisch leitenden Elementen (22) hergestellt werden.

24. Verfahren gemäß Anspruch 23, **dadurch gekennzeichnet, daß** die Gießformen (34) für die optisch leitenden Elemente (22) an den Enden (33), vorzugsweise unter 45°, abgeschrägte Flanken besitzen, durch diese Flanken (14) in der optischen Lage (13) angeformte Abschnitte (28) der optischen Lage nach der Entformung lokal (28) metallisiert werden und dann die Funktion von integrierten Umlenkspiegeln (14) besitzen.

25. Verfahren gemäß einem der vorstehenden Ansprüche, **dadurch gekennzeichnet, daß** die optisch leitenden Elemente (22) der optischen Lage (13) Kreuzungen, Verzweigungen, Mischer, Wellenlängenmultiplexer und Wellenlängendemultiplexer und Schaltelemente enthalten.

26. Verfahren gemäß einem der vorstehenden Ansprüche, **dadurch gekennzeichnet, daß** die optisch leitende Schicht (22) aus einem Polysiloxanmaterial eine Temperaturstabilität der optischen Lage der elektrisch-optischen Leiterplatte (11) etwa bei Lötvorgängen bis im wesentlichen 250 °C ohne Beeinträchtigung der optischen Eigenschaften der Elemente (22) der optischen Lage (13) zuläßt.

27. Verfahren gemäß einem der vorstehenden Ansprüche, **dadurch gekennzeichnet, daß** die Leiterplatten (24) aus glasfasergefülltem Epoxydharz und/oder Kapton und/oder Teflon und/oder Glas gebildet werden, die gar nicht oder einseitig oder beidseitig mit elektrisch leitenden Schichten (12) versehen sind.

28. Verfahren gemäß einem der vorstehenden Ansprüche, **dadurch gekennzeichnet, daß** die eingesetzten Leiterplatten (24) einseitig oder beidseitig mit elektrischen Leiterbahnen (12) versehen sind.

29. Verfahren gemäß einem der vorstehenden Ansprüche, **dadurch gekennzeichnet, daß** auf einer oder auf beiden Seiten des verfahrensmäßig hergestellten Verbundes aus optischer Lage (13) und mit der optischen Lage (13) verbundenen Schichten (24, 30) der Leiterplatte (11) weitere Schichten der Leiterplatte (11) oder weitere Leiterplatten (11) zu einem Multilayer-Verbund hinzugefügt werden.

30. Verfahren gemäß einem der vorstehenden Ansprüche, **dadurch gekennzeichnet, daß** der verfahrensmäßig hergestellte Verbund aus optischer Lage (13) und mit der optischen Lage (13) verbundenen Schichten (24, 30) der Leiterplatte (11) auf ein steifes Trägermedium aufgebracht wird.

31. Verfahren gemäß einem der vorstehenden Ansprüche, **dadurch gekennzeichnet, daß** der verfahrensmäßig hergestellte Verbund aus optischer Lage (13) und mit der optischen Lage (13) verbundenen Schichten (24, 30) der Leiterplatte (11) auf ein flexibles Trägermedium aufgebracht wird.

32. Verfahren gemäß einem der vorstehenden Ansprüche, **dadurch gekennzeichnet, daß** als optische Elemente (22) optische Leistungsteiler, optische Mischer, optische Schalter, optische Modulatoren, Wellenlängenmultiplexer, Wellenlängendemultiplexer oder optische Abschwächer verwendet werden.

## Claims

1. A method of producing an electro-optical printed circuit board (11) having a number of layers (24, 30) with electrically conducting elements (12) and at least one optical layer (13) with optically conducting elements (22), in particular with waveguides (22), wherein structuring of the elements (22) of the optical layer (13) is effected by means of casting into a casting mould (21) containing the waveguide structures in the form of a negative mould, wherein the mechanical connection between the optical layer (13) and the at least one layer (24, 30) of the electrically conducting printed circuit board layers is effected in direct connection with the production of the optical layer (13),
**characterised in that**
the at least one optical layer (13) has a polysiloxane material and in a first step pit structures (34) of a casting mould (21) are filled with core polysiloxane (22) having a higher refractive index and hardened and then a polysiloxane having a low refractive index is cast as a superstrate layer (23) and/or a substrate layer (29) on to at least the core polysiloxane (22) and is bonded to the core polysiloxane (22).

2. A method according to claim 1 **characterised in that** the mechanical connection between the optical layer (13) and the at least one layer (24, 30) of the electrically conducting printed circuit board layers is effected directly in the production of the elements (22) of the optical layer (13).

3. A method according to claim 2 **characterised in that** the optical layer (13) is formed from a core polysiloxane (22) having a higher refractive index and a polysiloxane having a low refractive index as a superstrate layer (23) and a polysiloxane having a low refractive index as a substrate layer (29) in the form of cover layers on the core polysiloxane (22).

4. A method according to claim 3 **characterised in that** the superstrate polysiloxane (23) is applied in liquid form to the core polysiloxane (22) which has already solidified, connected in its liquid phase to a layer (24, 30) of the electrically conducting printed circuit board layers and then cross-linked.

5. A method according to claim 3 **characterised in that** the substrate polysiloxane (29) is applied in liquid form to the core polysiloxane (23) which has already solidified, connected in its liquid phase to a layer (30) of the electrically conducting printed circuit board layers and then cross-linked.

6. A method according to one of claims 4 and 5 **characterised in that** after crosslinking of the polysiloxane layer of the substrate (29) or the superstrate (23) the one layer (24) of the electrically conducting printed circuit board layers is mechanically fixed to the polysiloxane layer (23, 29).

7. A method according to one of claims 3 to 6 **characterised in that** in a first step pit structures (34) of a casting mould (21) are filled with core polysiloxane (22) having a higher refractive index and hardened, in a second step a polysiloxane having a low refractive index is applied as a superstrate layer (23) in such a way that it bonds to the core polysiloxane (22), in a third step the superstrate layer (23) with the electrically conducting elements (22) disposed thereon are separated from the casting mould (21) and in a fourth step a polysiloxane having a low refractive index is applied as a substrate layer (29) to the core polysiloxane (22).

8. A method according to one of claims 3 to 6 **characterised in that** in a first step the polysiloxane substrate (29) having a low refractive index is produced with pit structures (34) by a casting procedure, in a second step a core polysiloxane (22) having a higher refractive index is filled into the pits (34) and in a third step a polysiloxane having a low refractive index is applied as a superstrate layer (23) to the composite of the polysiloxane substrate/core polysiloxane (29, 22).

9. A method according to one of claims 3 to 8 **characterised in that** the layer (24, 30) of the electrically conducting printed circuit board layers on the side towards the liquid polysiloxane of the substrate layer (29) or the superstrate layer (23) respectively has microstructured spacers (25, 31) which guarantee a defined thickness of the substrate layer (29) or the superstrate layer (23) respectively.

10. A method according to claim 1 **characterised in that** the mechanical connection between the optical layer (13) and the at least one layer (24, 30) of the electrically conducting printed circuit board layers is produced subsequently to production of the optical layer (13).

11. A method according to claim 10 **characterised in that** the optical layer (13) comprising polysiloxane substrate (29) and/or polysiloxane core (22) and/or polysiloxane superstrate (23) is firstly produced as an independent layer and then mechanically connected either at one side or both sides to one or more layers (24, 30) of the electrically conducting printed circuit board layers.

12. A method according to claim 11 **characterised in that** the connection of the optical layer (13) to a layer (24, 30) of the electrically conducting printed circuit layers is effected by lamination or glueing.

13. A method according to one of the preceding claims **characterised in that** the optically conducting layer (22) is handled jointly with the at least one layer (24, 30) of the electrically conducting printed circuit board layers during production of the electro-optical printed circuit board (11).

14. A method according to one of the preceding claims **characterised in that** bonding agents are used to promote the connection of the polysiloxane of the optical layer (13) to the layer (24, 30) of the electrically conducting printed circuit board layers.

15. A method according to claim 14 **characterised in that** a polymer layer which adheres well to the layer (24, 30) of the electrically conducting printed circuit board layers is applied as the bonding agent to the optical layer (13).

16. A method according to one of claims 1 to 13 **characterised in that** a physical and/or chemical treatment of the surface of the layer (24, 30) of the electrically conducting printed circuit board layers is effected, which is connected to the optical layer (13), to provide for activation of the surface for improved adhesion to the optical layer (13).

17. A method according to claim 16 **characterised in that** the layer (24, 30) of the electrically conducting printed circuit board layers which is mechanically connected to the optical layer (13) is influenced in its adhesion properties with respect to the optical layer (13) by means of flaming with gases.

18. A method according to claim 16 **characterised in that** the layer (24, 30) of the electrically conducting printed circuit board layers which is mechanically connected to the optical layer (13) is influenced in its adhesion properties with respect to the optical layer (13) by means of plasma irradiation.

19. A method according to one of the preceding claims **characterised in that** the casting procedures for structuring of the optically conducting elements (22) are effected substantially at ambient temperatures.

20. A method according to one of the preceding claims **characterised in that** when casting the optically conducting elements (22) the surface of the cast optically conducting elements (22) is smoothed off by doctor means and thus the casting mould (21) is completely filled.

21. A method according to one of the preceding claims **characterised in that** large-area structures of the optically conducting elements (22) can also be produced by the casting procedures for structuring of the optically conducting elements (22).

22. A method according to one of the preceding claims **characterised in that** by virtue of its elastic properties the polysiloxane material can also be shaped out of casting recesses (34) with very steep walls or recesses with undercut configurations without adverse effects.

23. A method according to one of the preceding claims **characterised in that** the coupling elements (14) for optical coupling of the optically conducting elements (22) to electrically conducting elements (15, 16, 17), that are to be functionally connected, of the electrically conducting printed circuit board layers (12) are produced at the same time when casting the optical layer (13) with the optically conducting elements (22).

24. A method according to claim 23 **characterised in that** the casting moulds (34) for the optically conducting elements (22) have bevelled flanks, preferably at 45°, at the ends (33), portions (28) of the optical layer that are moulded in the optical layer (13) by said flanks (14) are locally (28) metallised after removal from the mould and then have the function of integrated deflection mirrors (14).

25. A method according to one of the preceding claims **characterised in that** the optically conducting elements (22) of the optical layer (13) include intersections, branchings, mixers, wavelength multiplexers and wavelength demultiplexers and switching elements.

26. A method according to one of the preceding claims **characterised in that** the optically conducting layer (22) comprising a polysiloxane material permits temperature stability of the optical layer of the electro-optical printed circuit board (11) for example in soldering procedures up to substantially 250°C without impairment of the optical properties of the elements (22) of the optical layer (13).

27. A method according to one of the preceding claims **characterised in that** the printed circuit boards (24) are formed from glass fibre-filled epoxy resin and/or Kapton and/or Teflon and/or glass which are not provided at all with electrically conducting layers (12) or which are provided therewith on one or both sides.

28. A method according to one of the preceding claims **characterised in that** the printed circuit boards (24) used are provided with electrical conductor tracks (12) on one or both sides.

29. A method according to one of the preceding claims **characterised in that** further layers of the printed circuit board (11) or further printed circuit boards (11) are added to give a multi-layer composite on one or both sides of the composite produced by the method comprising the optical layer (13) and layers (24, 30) of the printed circuit board (11), that are connected to the optical layer (13).

30. A method according to one of the preceding claims **characterised in that** the composite produced by the method comprising the optical layer (13) and layers (24, 30) of the printed circuit board (11), that are connected to the optical layer (13), are applied to a stiff carrier medium.

31. A method according to one of the preceding claims **characterised in that** the composite produced by the method comprising the optical layer (13) and layers (24, 30) of the printed circuit board (11), that are connected to the optical layer (13), are applied to a flexible carrier medium.

32. A method according to one of the preceding claims **characterised in that** optical power splitters, optical mixers, optical switches, optical modulators, wavelength multiplexers, wavelength demultiplexers or optical attenuators are used as the optical elements (22).

## Revendications

1. Procédé pour la réalisation d'une carte de circuits imprimés électro-optique (11), présentant un certain nombre de couches (24, 30) avec des éléments électroconducteurs (12) et au moins une couche optique (13) avec des éléments à conductivité optique (22), en particulier avec des guides d'onde (22), la structuration des éléments (22) de la couche optique (13) ayant lieu par coulage dans un moule (21) comprenant les structures de guides d'onde en tant que moule négatif, la liaison mécanique entre la couche optique (13) et cette au moins une couche (24, 30) des couches de cartes de circuits imprimés électroconductrices étant réalisée en lien direct avec la fabrication de la couche optique (13),
**caractérisé en ce que**
cette ou ces couches optiques (13) présentent un matériau en polysiloxane et **en ce que** lors d'une première étape, des structures à sillons (34) d'un moule (21) sont remplies et durcies avec du polysiloxane nucléaire (22) à indice de réfraction supérieur et **en ce qu'**un polysiloxane à indice de réfraction faible est ensuite coulé en tant que couche de supersubstrat (23) et/ou en tant que couche de substrat (29) au moins sur le polysiloxane nucléaire (22) et se lie avec le polysiloxane nucléaire (22).

2. Procédé selon la revendication 1, **caractérisé en ce que** la liaison mécanique entre la couche optique (13) et cette ou ces couches (24, 30) des couches de cartes de circuits imprimés électroconductrices est réalisée directement lors de la fabrication des éléments (22) de la couche optique (13).

3. Procédé selon la revendication 2, **caractérisé en ce que** la couche optique (13) est formée par un polysiloxane nucléaire (22) à indice de réfraction supérieur ainsi qu'un polysiloxane à indice de réfraction faible en guise de couche de supersubstrat (23) et par un polysiloxane à indice de réfraction faible en guise de couche de supersubstrat (29) sous forme de couches de recouvrement sur le polysiloxane nucléaire (22).

4. Procédé selon la revendication 3, **caractérisé en ce que** le polysiloxane de supersubstrat (23) est appliqué sous forme liquide sur le polysiloxane nucléaire déjà durci (22), **en ce qu'**il est mis en liaison dans sa phase liquide avec une couche (24, 30) des couches de cartes de circuits imprimés électroconductrices en étant ensuite réticulé.

5. Procédé selon la revendication 3, **caractérisé en ce que** le polysiloxane de substrat (29) est appliqué sous forme liquide sur le polysiloxane nucléaire (22) déjà durci, **en ce qu'**il est mis en liaison au cours de sa phase liquide avec une couche (30) des couches de cartes de circuits imprimés électroconductrices en étant ensuite réticulé.

6. Procédé selon l'une des revendications 4 ou 5, **caractérisé en ce qu'**après la réticulation de la couche de polysiloxane du substrat (29) ou du supersubstrat (23), cette couche (24) des couches de cartes de circuits imprimés électroconductrices est fixée de manière mécanique sur la couche de polysiloxane (23, 29).

7. Procédé selon l'une des revendications 3 à 6, **caractérisé en ce que** lors d'une première étape, des structures à sillons (34) d'un moule (21) sont remplies et durcies avec du polysiloxane nucléaire (22) à indice de réfraction supérieur, **en ce que** lors d'une deuxième étape, on applique un polysiloxane à indice de réfraction faible en guise de couche de supersubstrat (23) de manière à ce que ce qu'elle se lie au polysiloxane nucléaire (22), **en ce que** lors d'une troisième étape, la couche de supersubstrat (23) avec les éléments à conductivité optique (22) se trouvant sur elle est séparée du moule (21) et **en ce que** lors d'une quatrième étape, on applique un polysiloxane à indice de réfraction faible en guise de couche de supersubstrat (29) sur le polysiloxane nucléaire (22).

8. Procédé selon l'une des revendications 3 à 6, **caractérisé en ce que** lors d'une première étape, le substrat de polysiloxane à indice de réfraction faible (29) est fabriqué par technique de coulage avec des structures à sillons (34), **en ce que** lors d'une deuxième étape, les sillons (34) sont remplis avec un polysiloxane nucléaire à indice de réfraction supérieur (22) et **en ce que** lors d'une troisième étape, on applique du polysiloxane à indice de réfraction faible en guise de couche de supersubstrat (23) sur la liaison de substrat de polysiloxane/polysiloxane nucléaire (29, 22).

9. Procédé selon l'une des revendications 3 à 8, **caractérisé en ce que** la couche (24, 30) des couches de cartes de circuits imprimés électroconductrices présente, sur le côté tourné vers le polysiloxane liquide de la couche de substrat (29) et/ou de la couche de supersubstrat (23), des éléments d'espacement microstructurés (25, 31), lesquels garantissent une épaisseur définie de la couche de substrat (29) et/ou de la couche de supersubstrat (23).

10. Procédé selon la revendication 1, **caractérisé en ce que** la liaison mécanique entre la couche optique (13) et cette ou ces couches (24, 30) des couches de cartes de circuits imprimés électroconductrices est réalisée suite à la fabrication de la couche optique (13).

11. Procédé selon la revendication 10, **caractérisé en ce que** la couche optique (13) se composant d'un substrat de polysiloxane (29) et/ou de polysiloxane nucléaire (22) et/ou d'un supersubstrat de polysiloxane (23) est tout d'abord fabriquée en tant que couche autonome et est ensuite mise en liaison mécanique, soit d'un seul côté soit des deux côtés, avec une ou plusieurs couches (24, 30) des couches de cartes de circuits imprimés électroconductrices.

12. Procédé selon la revendication 11, **caractérisé en ce que** la liaison entre la couche optique (13) et une couche (24, 30) des couches de cartes de circuits imprimés électroconductrices s'effectue par laminage ou collage.

13. Procédé selon l'une des revendications précédentes, **caractérisé en ce que** la couche à conductivité optique (22) est manipulée pendant la fabrication de la carte de circuits imprimés à conductivité électro-optique (11) ensemble avec cette ou ces couches (24, 30) des couches de cartes de circuits imprimés électroconductrices.

14. Procédé selon l'une des revendications précédentes, **caractérisé en ce que**, pour renforcer la liaison entre le polysiloxane de la couche optique (13) et la couche (24, 30) des couches de cartes de circuits imprimés électroconductrices, on utilise un agent adhésif.

15. Procédé selon la revendication 14, **caractérisé en ce qu'**en guise d'agent adhésif, on applique sur la couche optique (13) une couche polymère adhérant bien sur la couche (24, 30) des couches de cartes de circuits imprimés électroconductrices.

16. Procédé selon l'une des revendications 1 à 13, **caractérisé en ce que** l'on procède à un traitement physique et/ou chimique de la surface de la couche (24, 30) des couches de cartes de circuits imprimés électroconductrices, laquelle est mise en liaison avec la couche optique (13) afin d'obtenir une activation de la surface pour une meilleure adhésion avec la couche optique (13).

17. Procédé selon la revendication 16, **caractérisé en ce que** la couche (24, 30) des couches de cartes de circuits imprimés électroconductrices, laquelle est mise en liaison mécanique avec la couche optique (13), est influencée concernant ses propriétés adhésives par rapport à la couche optique (13) à l'aide d'un flambage avec des gaz.

18. Procédé selon la revendication 16, **caractérisé en ce que** la couche (24, 30) des couches de cartes de circuits imprimés électroconductrices, laquelle est mise en liaison mécanique avec la couche optique (13), est influencée concernant ses propriétés adhésives par rapport à la couche optique (13) à l'aide d'une irradiation au plasma.

19. Procédé selon l'une des revendications précédentes, **caractérisé en ce que** les techniques de coulage pour la structuration des éléments à conductivité optique (22) sont essentiellement réalisées à températures ambiantes.

20. Procédé selon l'une des revendications précédentes, **caractérisé en ce que** lors du coulage des éléments à conductivité optique (22), la surface des éléments à conductivité optique (22) coulés est enlevée par raclage et **en ce que** le moule (21) est ainsi entièrement rempli.

21. Procédé selon l'une des revendications précédentes, **caractérisé en ce que** grâce aux techniques de coulage pour la structuration des éléments à conductivité optique (22), il est également possible de fabriquer des structures à grande superficie des éléments à conductivité optique (22).

22. Procédé selon l'une des revendications précédentes, **caractérisé en ce que** le matériau de polysiloxane, en raison de ses propriétés d'élasticité, peut également être démoulé sans inconvénients de creux (34) de coulage avec des parois très raides ou de creux à contre-dépouille.

23. Procédé selon l'une des revendications précédentes, **caractérisé en ce que** les éléments d'accouplement (14) pour l'accouplement optique des éléments à conductivité optique (22) avec des éléments électroconducteurs (15, 16, 17) à relier de manière fonctionnelle des couches de cartes de circuits imprimés électroconductrices (12), sont fabriqués simultanément lors du coulage de la couche optique (13) avec les éléments à conductivité optique (22).

24. Procédé selon la revendication 23, **caractérisé en ce que** les moules (34) pour les éléments à conductivité optique (22) possèdent aux extrémités (33) des flancs chanfreinés de préférence de 45°, des tronçons (28) de la couche optique formés dans la couche optique (13) étant localement métallisés (28) grâce à ces flancs (14) après le démoulage et présentant alors la fonction de miroirs de déviation intégrés (14).

25. Procédé selon l'une des revendications précédentes, **caractérisé en ce que** les éléments à conductivité optique (22) de la couche optique (13) comprennent des croisements, des jonctions, des mélangeurs, des multiplexeurs de longueur d'ondes et des démultiplexeurs de longueur d'ondes et des éléments de commutation.

26. Procédé selon l'une des revendications précédentes, **caractérisé en ce que** la couche à conductivité optique (22) en un matériau de polysiloxane admet une stabilité thermique de la couche optique de la carte de circuits imprimés électro-optique (11) lors des processus de soudage jusqu'à environ 250°C sans altérer les propriétés optiques des éléments (22) de la couche optique (13).

27. Procédé selon l'une des revendications précédentes, **caractérisée en ce que** les cartes de circuits imprimés (24) sont formées avec de la résine époxy remplie de fibres de verre et/ou du Kapton et/ou du Téflon et/ou du verre, lesquelles ne sont pas munies de couches électroconductrices (12), ou en sont munies d'un côté ou des deux côtés.

28. Procédé selon l'une des revendications précédentes, **caractérisé en ce que** les cartes de circuits imprimés (24) utilisées sont garnies d'un côté ou des deux côtés de pistes conductrices électriques (12).

29. Procédé selon l'une des revendications précédentes, **caractérisé en ce que** l'on ajoute, sur un côté ou les deux côtés de la liaison réalisée selon l'invention entre une couche optique (13) et des couches (24, 30) de la carte de circuits imprimés (11) en liaison avec la couche optique (13), d'autres couches de la carte de circuits imprimés (11) ou d'autres cartes de circuits imprimés (11) pour donner une liaison à couches multiples.

30. Procédé selon l'une des revendications précédentes, **caractérisé en ce que** la liaison réalisée selon l'invention entre une couche optique (13) et des couches (24, 30) de la carte de circuits imprimés (11) en liaison avec la couche optique (13) est appliquée sur un support rigide.

31. Procédé selon l'une des revendications précédentes, **caractérisé en ce que** la liaison réalisée selon l'invention entre une couche optique (13) et des couches (24, 30) de la carte de circuits imprimés (11) en liaison avec la couche optique (13) est appliquée sur un support flexible.

32. Procédé selon l'une des revendications précédentes, **caractérisé en ce que** l'on utilise en guise d'éléments optiques (22) des diviseurs de puissance optique, des mélangeurs optiques, des commutateurs optiques, des modulateurs optiques, des multiplexeurs de longueur d'ondes, des démultiplexeurs de longueur d'ondes ou des atténuateurs optiques.
